Europäisches Patentamt

European Patent Office

Office européen des brevets

(11) Publication number: **0 031 638**
**B1**

# EUROPEAN PATENT SPECIFICATION

(45) Date of publication of patent specification: **03.10.84**

(21) Application number: **80303960.1**

(22) Date of filing: **06.11.80**

(51) Int. Cl.³: **H 03 K 21/36,** H 03 K 23/00, G 11 C 19/00

(54) **A logic circuit.**

(30) Priority: **09.11.79 JP 145105/79**

(43) Date of publication of application:
**08.07.81 Bulletin 81/27**

(45) Publication of the grant of the patent:
**03.10.84 Bulletin 84/40**

(84) Designated Contracting States:
**DE FR GB NL**

(56) References cited:
**US-A-3 146 345**
**US-A-3 374 339**
**US-A-3 906 195**
**US-A-3 978 413**

(73) Proprietor: **FUJITSU LIMITED**
**1015, Kamikodanaka Nakahara-ku**
**Kawasaki-shi Kanagawa 211 (JP)**

(72) Inventor: **Sugihara, Takanori**
**No. 479-3, Higashinaganuma**
**Inagi-shi Tokyo, 192-02 (JP)**
Inventor: **Yoshida, Makoto**
**No. 764, Shimokodanaka Nakahara-ku**
**Kawasaki-shi Kanagawa, 211 (JP)**

(74) Representative: **Bedggood, Guy Stuart et al**
**Haseltine Lake & Co. Hazlitt House 28**
**Southampton Buildings Chancery Lane**
**London WC2A 1AT (GB)**

Courier Press, Leamington Spa, England.

## Description

The present invention relates to a logic circuit.

When an initial value is to be input to a counter and a count result taken out from the counter after a predetermined count operation has been effected, a small scale integrated circuit (SSI) or the like which performs parallel input of the initial value to the counter and parallel output therefrom of the count result can be used, without any particular problems, when the number of bits of data to be handled is small. In a large scale integrated circuit (LSI), however, the provision of such parallel input of the initial value to the counter from the outside thereof and parallel output of the count result presents difficulties because of an increase in the number of bits of data to be handled and a limitation on the number of pins available for use. Therefore, it has been general practice to supply initial value data in serial form from the outside, convert the initial value data, by means of a serial-parallel converting register, to parallel form for input to the counter and to convert the count result, supplied from the counter in parallel form, into serial form for output by means of a parallel-serial converting register.

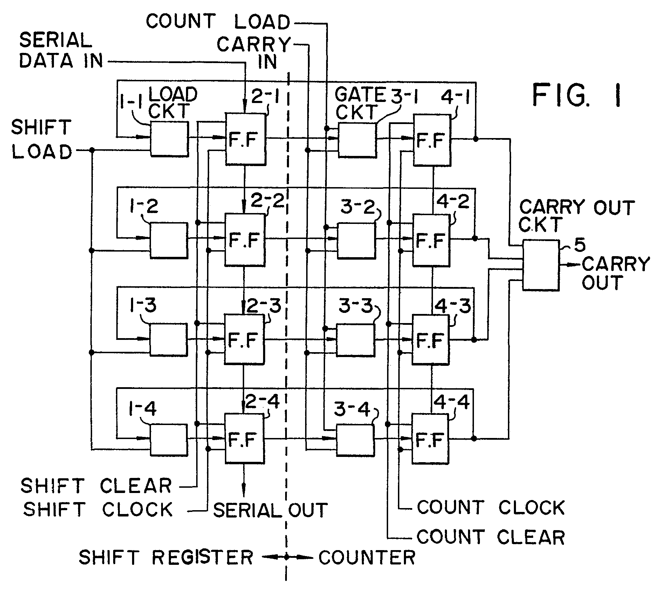

Fig. 1 of the accompanying drawings is a schematic diagram which illustrates the arrangement of a conventional 4-bit counter/shift register employing a shift register and a counter. In Fig. 1, on the lefthand side of the broken line is a shift register part and on the right-hand side of the broken line is a counter part. Reference numerals 1-1, 1-2, 1-3 and 1-4 indicate circuits for loading data in parallel; 2-1, 2-2, 2-3 and 2-4 designate cascade-connected flip-flops (FF), each of which is usually a delay (D) flip-flop or delay (D) latch; 3-1, 3-2, 3-3 and 3-4 identify gate circuits for loading data in the counter part and causing it to perform a count operation; 4-1, 4-2, 4-3 and 4-4 denote cascade-connected flip-flops (FF), each of which is usually a J-K flip-flop; and 5 represents a carry output circuit.

The circuit of Fig. 1 performs, for example, the following operations: Firstly, the initial set value of each bit of an initial count value to be set in the counter is set in the shift register part. This is achieved by raising the level of a signal at a SHIFT LOAD terminal to a high level "H" to set the bits of the initial count value for the counter in respective bits of the shift register part from a terminal SERIAL DATA IN (or SHIFT DATA IN).

Needless to say, it is possible, in this case, to set each bit of the counter to a low level "L" by a signal at a COUNT CLEAR terminal.

Next, by raising the level of a signal at a COUNT LOAD terminal to the high level "H", the initial count value is loaded in the counter part from the shift register part.

The counting operation is carried out in the following manner: Firstly, the level of a signal at a terminal COUNT LOAD is brought down to a low level "L" and, at this time, a carry signal is applied to a terminal CARRY IN. When the signal at the terminal CARRY IN is at its high level, a carry exists and when the level of this signal is low, no carry exists.

Upon completion of the counting operation, the count result is loaded in the shift register part. This is performed by bringing down the level of the signal at the terminal SHIFT LOAD to the low level. Thereafter, each data bit held in the shift register part is output to a terminal SERIAL OUT.

In Figure 1, a SHIFT CLEAR terminal is employed for a signal for clearing the shift register part, SHIFT CLOCK and COUNT CLOCK terminals are employed for clock signals for the shift register and counter parts, and CARRY OUT terminal is for sending out carry data.

Fig. 2 of the accompanying drawings is a schematic block circuit diagram showing a specific example of a circuit arrangement for a counter/register as depicted in Fig. 1. In Fig. 2, parts corresponding to those in Fig. 1 are identified by the same reference numerals and characters.

For example, the load circuits 1-1 to 1-4, may each be formed by two gates, and accordingly eight gates would be needed in the load circuit part. The delay (D-Type) flip-flops 2-1 to 2-4 may each be constituted by six gates; hence, 24 gates would be required. The gates 3-1 to 3-4 may require 35 gates in all. The J-K flip-flops 4-1 to 4-4 may each be constituted by eight gates, and consequently 32 gates would be required. Therefore, a counter/shift register as shown in Fig. 1, not including the carry output circuit and so forth, can require a total of about 99 gates.

As described above, the conventional circuit employs a register part of the same bit capacity as the counter part for serial-input, count and serial-output operations. Accordingly, for n-bit counting, the entire circuit arrangement including the register requires 2n flip-flops, along with a large number of gates.

US—A—3 906 195 discloses a counter employing a plurality of cascade connected J-K flip-flops. Each flip-flop has a data input part connected to a logical gate group having gates arranged to be opened and closed by shift and count signals. The logical gate groups are arranged so that the flip-flops can serve alternatively as a shift register and a counter, in response to the shift and count signals.

In the counter of US—A—3 906 195 an initial value is entered into the counter in parallel form, using a separate input for each flip-flop. The shift operation provided is in the form of a ring in which the output of a last flip-flop is fed to a first flip-flop.

US—A—3 978 413 discloses a counter circuit, employing a plurality of cascade connected flip-flops, which can also act as a shift register for serial shifting of data from an input terminal through the flip-flops. The circuit employs logic gates connected to clock inputs of the flip-flops which are arranged so that the flip-flops can serve alternatively as a shift register and a counter in response to shift and count enable signals.

According to the present invention, there is provided a logical circuit having a plurality of cascade-connected flip-flops, each flip-flop having connected to a data input part thereof a logical gate group, the logical gate group of each flip-flop comprising gates arranged to be opened and closed by a shift signal and by a count signal, and the logical gate groups being arranged so that the flip-flops serve alternatively to provide a shift register and a counter, in response to the shift signal and the count signal respectively, characterised in that the logical gate group connected to an nth $(n=1, 2, 3, \ldots)$ flip-flop has a construction which embodies the following expression, or its inverse, or logical equivalents of either,

$$D_n=\overline{SHT} \cdot Q_{(n-1)}+CNT(CRY \cdot \overline{Q}_n+\overline{CRY} \cdot Q_n)$$

where $D_n$ is data to be input to the nth flip-flop and is the data output from the logical gate group connected to the nth flip-flop; $\underline{SHT}$ is the shift signal; CNT is the count signal and bears a relationship to the shift signal such that $CNT=\overline{SHT}$; $Q_n$ is the Q output from the nth flip-flop; $\overline{Q}_n$ is the $\overline{Q}$ output from the nth flip-flop; $Q_{(n-1)}$ is the Q output from the $(n-1)$th flip-flop, which is externally supplied input data in the case of the logical gate group connected to the first flip-flop; and $CRY=Q_1 \cdot Q_2 \ldots \cdot Q_{(n-1)}$ and is taken to have the logical value "1" in the case of the logical gate group connected to the first flip-flop.

An embodiment of the present invention provides a logical circuit in which serial input data, corresponding to an initial count value to be loaded into the circuit, is shifted into the flip-flops.

Since shift register and counter functions do not overlap in their operational timings, it is possible to perform both the shift and count functions by one flip-flop as opposed to the two necessary in the conventional circuit depicted in Fig. 1.

Reference is made, by way of example, to the accompanying drawings, in which:—

Fig. 1 is a schematic block diagram showing the construction of a conventional counter/shift register employing a shift register and a counter;

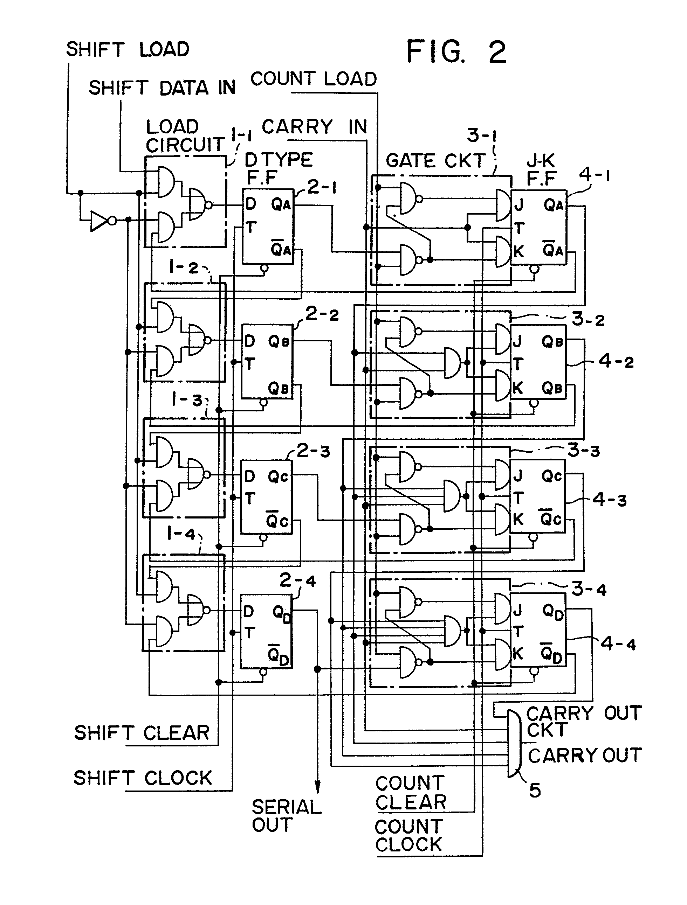

Fig. 2 is a schematic block circuit diagram illustrating a specific example of the basic circuit arrangement of the counter/shift register shown in Fig. 1;

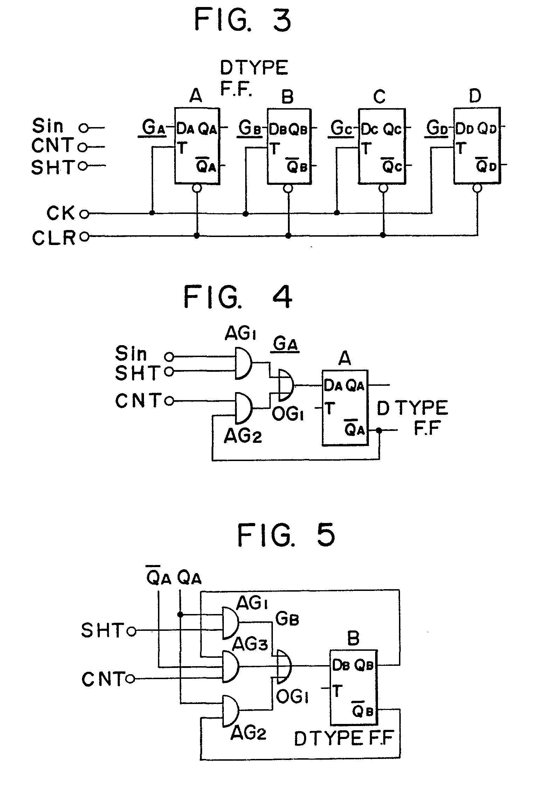

Fig. 3 is a schematic block diagram illustrating the general outline of a 4-bit delay flip-flop arrangement embodying the present invention;

Fig. 4 is a block circuit diagram illustrating the construction of a logical gate for dealing with a first bit in the arrangement of Fig. 3;

Fig. 5 is a block circuit diagram illustrating the construction of a logical gate for dealing with a second bit in the arrangement of Fig. 3;

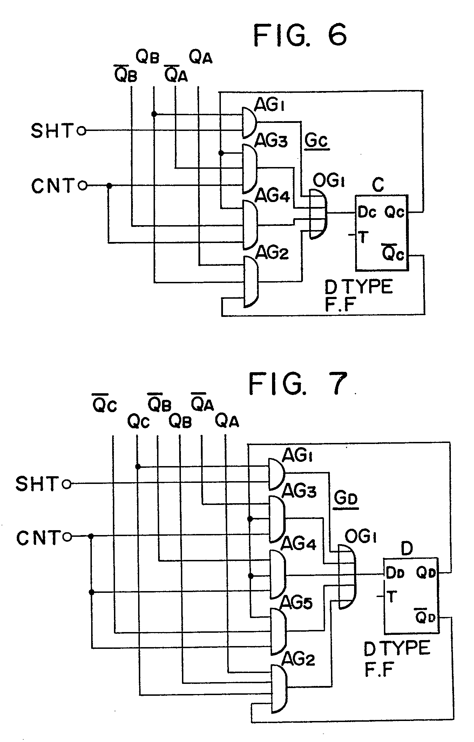

Fig. 6 is a block circuit diagram illustrating the construction of a logical gate for dealing with a third bit in the arrangement of Fig. 3;

Fig. 7 is a block circuit diagram illustrating the construction of a logical gate for dealing with a fourth bit in the arrangement of Fig. 3;

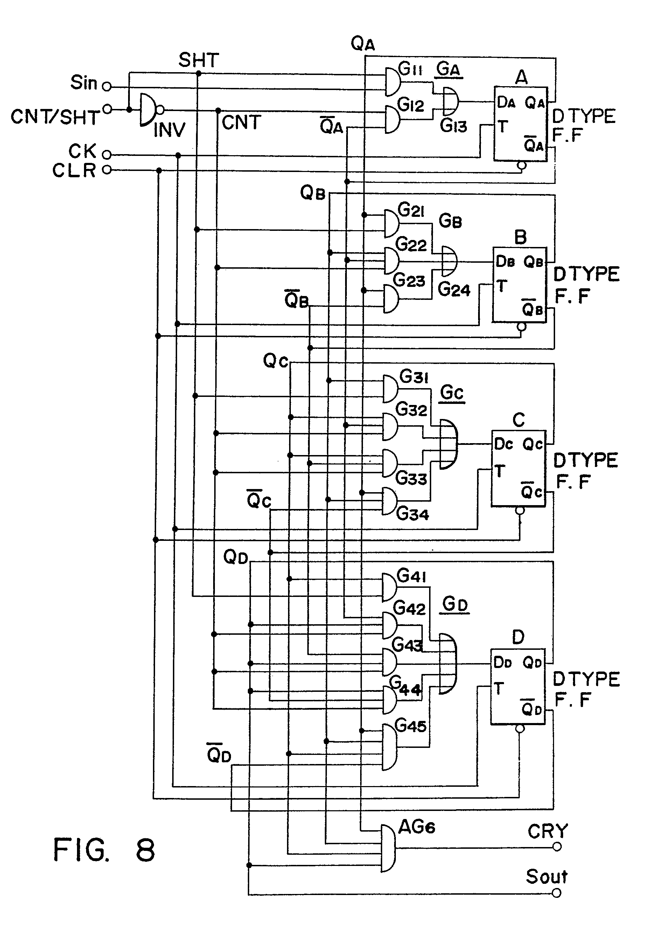

Fig. 8 is a circuit diagram showing the arrangement of a 4-bit counter/shift register with the logical gates shown in Figs. 4 to 7;

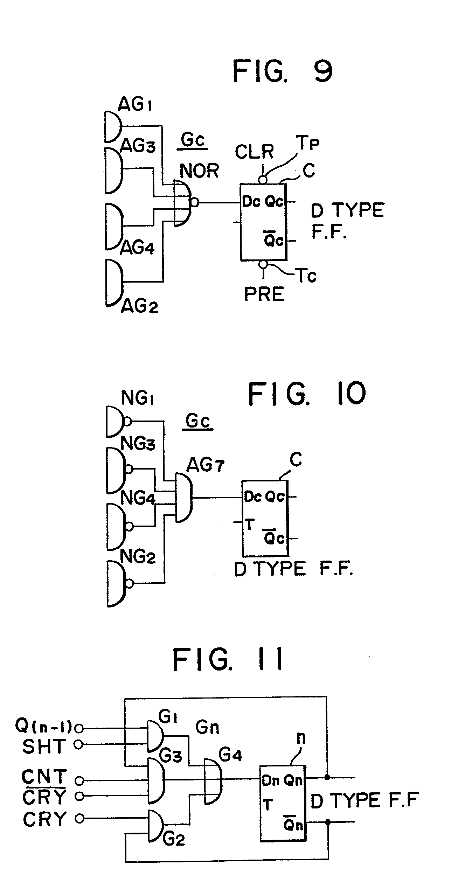

Figs. 9 and 10 are block circuit diagrams illustrating respective different constructions for logical gates as in Figs. 4 to 7; and

Fig. 11 is a schematic block circuit diagram illustrating the general features of construction of logical gates in an embodiment of this invention.

In Fig. 3 there is illustrated the general outline of a circuit (hereinafter referred to simply as a counter) which comprises four (D-type) flip-flop stages A to D which deal with first to fourth bits and has the functions of a shift register and a counter and in which the flip-flops A to D are driven by a common clock CK and reset (cleared) by a common clear signal CLR. In input stages of the flip-flops A to D there are respectively provided logical gates $G_A$ to $G_D$ which are shown in Figs. 4 to 7. In Fig. 3, reference characters Sin indicates shift data (initial data to be preset in the counter) which is input to the counter in serial form; SHT designates a shift mode signal (which indicates a shift operation for the counter when it is at a high level "H"); and CNT identifies a count mode signal (which indicates a count operation for the counter when it is at a high level "H"). The shift mode signal SHT and the count mode signal CNT bear the following relationship:

$$SHT=\overline{CNT} \tag{1}$$

The logical gate $G_A$ of first flip-flop stage A, dealing with a first bit, is so set as to fulfil the following conditions: During shift, since shift data Sin is being input, data input $D_A$ to the flip-flop A may be as given by the following expressions:

$$D_A=SHT \cdot Sin \tag{2}$$

Expression (2) means that in the shift mode, the data input $D_A$ is the shift data Sin. During

3

counting the circuit element dealing with the first bit is required only to perform a toggle operation, so that the data input $D_A$ to the flip-flop A may be as given by the following expression:

$$D_A = CNT \cdot \overline{Q}_A \tag{3}$$

Expression (3) means that in the count mode, the data input $D_A$ is $\overline{Q}_A$.

$\overline{Q}_A$ is the $\overline{Q}$ output from the flip-flop A and the inverse of the Q output $Q_A$ of flip-flop A. Characters B, C and D when applied as suffixes to Q and $\overline{Q}$ similarly relate to outputs of flip-flops B, C and D.

Accordingly, in order for the logical gate $G_A$ to be equipped with both count and shift functions, it suffices, from expressions (2) and (3), that the data input $D_A$ is as follows:

$$D_A = SHT \cdot Sin + CNT \cdot \overline{Q}_A \tag{4}$$

Fig. 4 shows a logical gate embodying expression (4). In Fig. 4, an AND gate $AG_1$ provides functions corresponding to expression (2), an AND gate $AG_2$ provides functions corresponding to expression (3) and an OR gate $OG_1$ provides that expression (4) is fully embodied.

In logical gate $G_B$ for dealing with a second bit B, during shifting, the output $Q_A$ of the preceding stage is applied as data input $D_B$ to the flip-flop B so the data input $D_B$ may be as given by the following expression:

$$D_B = SHT \cdot Q_A \tag{5}$$

During counting, when $Q_A = 1$ (in the case of a carry from the first bit stage A), since the logical gate $G_B$ is required only to perform a toggle operation, the data input $D_B$ to the flip-flop B may be as given by the following expression:

$$D_B = \overline{Q}_B \tag{6}$$

During counting, when $Q_A = 0$ (in the case of no carry from the first bit A), it is necessary that the status be invariable, and in this case, the data input $D_B$ may be as given by the following expression:

$$D_B = Q_B \tag{7}$$

Combining expressions (6) and (7), it follows that, during counting,

$$D_B = CNT (Q_A \cdot \overline{Q}_B + \overline{Q}_A \cdot Q_B) \tag{8}$$

Accordingly, in order that the logical gate $G_B$ may be equipped with shift and count functions, the data input $D_B$ becomes, from expressions (5) and (8), as follows:

$$D_B = SHT \cdot Q_A + CNT(Q_A \cdot \overline{Q}_B + \overline{Q}_A \cdot Q_B) \tag{9}$$

Using expression (1), expression (9) can be simplified as follows:

$$
\begin{aligned}
D_B &= SHT \cdot Q_A + CNT(Q_A \cdot \overline{Q}_B + \overline{Q}_A \cdot Q_B) \\
&= SHT \cdot Q_A + \overline{SHT} \cdot Q_A \cdot \overline{Q}_B + CNT \cdot \overline{Q}_A \cdot Q_B \\
&= SHT \cdot Q_A + Q_A \cdot \overline{Q}_B + CNT \cdot \overline{Q}_A \cdot Q_B
\end{aligned}
\tag{10}
$$

Fig. 5 shows a logical gate embodying expression (10). In Fig. 5, AND gates $AG_1$, $AG_2$ and $AG_3$ respectively provide functions corresponding to the right hand first, second and third terms of expression (10), an OR gate $OG_1$ obtains the logical sum of the first to third terms of expression (10).

Also, with respect to third and fourth bits C and D, the logical gates $G_C$ and $C_D$ are similarly constituted, with only carry conditions increasing in complexity. Logical gate $G_C$ dealing with the third bit C is set so that data input $D_C$ to the flip-flop C satisfies the following condition:

$$
\begin{aligned}
D_C &= SHT \cdot Q_B + CNT((Q_A \cdot Q_B)\overline{Q}_C + (\overline{Q_A \cdot Q_B})Q_C) \\
&= SHT \cdot Q_B + Q_A \cdot Q_B \cdot \overline{Q}_C + CNT(\overline{Q}_A + \overline{Q}_B)Q_C
\end{aligned}
\tag{11}
$$

Fig. 6 shows a logical gate embodying expression (11). In Fig. 6, AND gates $AG_1$ to $AG_4$ respectively provide functions corresponding to the right hand first to fourth terms (third term: $CNT \cdot \overline{Q}_A \cdot Q_C$, fourth term: $CNT \cdot \overline{Q}_B \cdot Q_C$) of expression (11), and an OR gate $OG_1$ obtains the logical sum of the first to fourth terms and executes the expression (11). Likewise, a logical gate $G_D$ for dealing with the fourth bit D is set so that data input $D_D$ to the flip-flop D satisfies the following condition:

$$
\begin{aligned}
D_D &= SHT \cdot Q_C + CNT((Q_A \cdot Q_B \cdot Q_C)\overline{Q}_D + (\overline{Q_A \cdot Q_B \cdot Q_C})Q_D) \\
&= SHT \cdot Q_C + Q_A \cdot Q_B \cdot Q_C \cdot \overline{Q}_D + CNT(\overline{Q}_A + \overline{Q}_B + \overline{Q}_C)Q_D
\end{aligned}
\tag{12}
$$

4

Fig. 7 shows a logical gate embodying expression (12). In Fig. 7, AND gates $AG_1$ to $AG_5$ correspond to the right hand first to fifth terms of the expression (12) and OR gate $OG_1$ obtains the logical sum of the first to fifth terms and executes the expression (12).

Fig. 8 illustrates a 4-bit counter/shift register in which the logical gates shown in Figs. 4 to 7 are interposed in the arrangement of Fig. 3. Since the signals SHT and CNT bear the relationship SHT=CNT, the signal CNT/SHT which becomes high-level in the shift mode is applied to an inverter INV; in this case, the shift signal SHT is used as input to the inverter and the counter signal CNT is given by the output of the inverter. When the shift signal SHT becomes high-level, gates $G_{11}$, $G_{21}$ and $G_{31}$ and $G_{41}$ are opened and the serial data Sin input in synchronism with clock CK is provided via the AND gate $G_{11}$ and an OR gate $G_{13}$ to the input terminal $D_A$ of the flop-flop A and read out in a sequential order. The output $Q_A$ from the flip-flop A is applied via the AND gate $G_{21}$ and an OR gate $G_{24}$ to the input terminal $D_B$ of the flip-flop B and read therein by the clock input. Also in respect of flip-flops C and D, operations similar to those mentioned above are performed. Accordingly, when serial data Sin of, for example, four bits is input, the bits are stored in the flip-flops D, C, B and A. In this way, the counter is initialized. Next, by making the signal CNT/SHT low-level, and hence the signal SHT low-level and the signal CNT high-level, the aforesaid gates $G_{11}$, $G_{21}$, $G_{31}$ and $G_{41}$ are closed but instead AND gates $G_{12}$, $G_{22}$, $G_{32}$, $G_{33}$, $G_{42}$, $G_{43}$ and $G_{44}$ are opened and, in the input gate groups of the flip-flops A to D of the first to fourth stages, arithmetic operations corresponding to the right hand second term of the expression (4) and the right hand second and third terms of the expressions (10), (11) and (12) are carried out; namely a count-up operation takes place. Next, when the signal CNT/SHT becomes high-level again, next serial data Sin is sequentially set in the flip-flops A to D (in the absence of the next data, the data Sin is made a continuation of 1 or 0) and count results are sequentially output from a terminal Sout.

An AND gate $AG_6$ in Fig. 8 obtains the logical product of Q outputs from the respective flip-flops to yield a carry output CRY of the first to fourth bits. The output CRY is used when the number of counter stages is increased.

In the circuit of Fig. 8, since the delay flip-flops A to D are each constituted by six gates for example, the number of gates required for the flip-flops is 24, and since about 22 other gates are needed, approximately 46 gates in all are required. Accordingly, the number of gates used in the circuit of the present invention is about 1/2 that needed in the conventional circuit arrangement of Fig. 2.

Figs. 9 and 10 show modified forms of the logical gate $G_c$ (similar modifications can be applied to the other logical gates). In Fig. 9, the OR gate $OG_1$ in Fig. 6 is replaced with a NOR gate (OR inverter) NOR. With such an arrangement, since the output from the NOR gate NOR is reversed in level as compared with the output from the OR gate $OG_1$, it is necessary to handle the data input $D_c$ as $\overline{D}_c$, reverse the outputs $Q_c$ and $\overline{Q}_c$ ($Q_c \rightarrow \overline{Q}_c$, $\overline{Q}_c \rightarrow Q_c$), apply the clear signal CLR to a preset terminal Tp and, conversely, apply a preset signal PRE to a clear terminal Tc. In Fig. 10, the AND gates $AG_1$ to $AG_4$ in Fig. 6 are replaced by NAND gates $NG_1$ to $NG_4$ and the OR gate $OG_1$ in Fig. 6 is replaced by an AND gate $AG_7$. Also, in this case, the output from the AND gate $AG_7$ is reversed in level as compared with the output from the OR gate $OG_1$, and accordingly the same operations as those described in respect of Fig. 9 are required.

A counter/shift register of more than four bits can be formed by using a plurality of such 4-bit counter/shift registers and the number of bits dealt with by one block can also be changed suitably. A counter/shift register of an arbitrary number of bits can be constituted as follows: A logical gate $G_n$ for dealing with an nth bit is formed as shown in Fig. 11 since the data input $D_n$ is such as is given by the following expression:

$$D_n = SHT \cdot Q_{(n-1)} + CNT(CRY \cdot \overline{Q}_n + \overline{CRY} \cdot Q_n) \qquad (13)$$

where $CRY = Q_1 \cdot Q_2 \ldots \cdot Q_{(n-1)}$ and is taken to have logical value "1" for the Gate $G_1$. The right hand first, second and third terms of the expression (13) can be embodied respectively by gates $G_1$, $G_2$ and $G_3$ in Fig. 11 and their logical sum can be embodied by a gate $G_4$ in Fig. 11.

From the foregoing explanation it will be understood that in respect of the logical gates $G_2$, $G_3$, $G_4$ etc, for dealing with the second and subsequent bits, expression (13) can be simplified to:—

$$D_n = SHT \cdot Q_{(n-1)} + CRY \cdot \overline{Q}_n$$
$$+ CNT \cdot \overline{CRY} \cdot Q_n.$$

CNT can be omitted from the second term because when SHT=1 (and CNT=0) $CRY \cdot \overline{Q}_n$ (n>1) cannot produce a value of $D_n$ different from that which would be obtained from $SHT \cdot Q_{(n-1)}$ alone.

The gates $G_1$ to $G_3$ are AND gates, each having an AND function, or NAND gates, and the gate $G_4$ is an OR gate having OR function or a NOR gate, as described previously. Generalizing the present invention as shown in Fig. 11, a counter/shift register of a desired number of bits can be formed, but by connecting a plurality of such circuits together in stages, it is also possible to constitute a counter/shift register in which the number of bits is an integral multiple of the number of stages. Further, the flip-flops used need not always be D flip-flops but may also be J-K flip-flops.

The logical circuit embodying the present invention described above has a count function and a

5

shift function, and hence is a general purpose circuit. That is, the logical circuit embodying the present invention is capable of performing independently the operations of a counter, independently the operations of a shift register and compound operations of serial input of data and serial output of data after counting. In addition, the logical circuit can be formed to deal with a desired number of bits, the number of flip-flops is limited to the number required for constituting the counter and, further, the number of gates used is smaller than are needed if the counter and the register are provided separately. Accordingly, the present invention is of particular utility when applied to master slice system LSI which is limited in the number of gates available.

Thus, an embodiment of the present invention provides logical circuit which is capable of serving not only as a shift register but also as counter. The circuit comprises a cascade-connection of flip-flops the same in number as the bits to be dealt with by the circuit. The flip-flops are provided each in its input part with a logical gate group composed of gates which are opened and closed by a shift signal and a count signal. The logical circuit does not require separate flip-flop groups in a shift register part and in a counter part as is needed in a conventional shift register/counter circuit. The logical circuit is capable of performing independent shift register operations, independent counter operations and a compound operation involved in the input of data in serial form for initialization and the output of counted data in serial form. With a logical circuit embodying the present invention, the number of gates used is greatly reduced as compared with the conventional shift register/counter circuit; accordingly, a circuit embodying the present invention is of particular utility when formed as a large scale integrated circuit.

## Claims

1. A logical circuit having a plurality of cascade-connected flip-flops, each flip-flop having connected to a data input part thereof a logical gate group, the logical gate group of each flip-flop comprising gates arranged to be opened and closed by a shift signal and by a count signal, and the logical gate groups being arranged so that the flip-flops serve alternatively to provide a shift register and a counter, in response to the shift signal and the count signal respectively, characterised in that the logical gate group connected to an nth ($n=1, 2, 3, \ldots$) flip-flop has a construction which embodies the following expression, or its inverse, or logical equivalents of either,

$$D_n = SHT \cdot Q_{(n-1)} + CNT(CRY \cdot \overline{Q}_n + \overline{CRY} \cdot Q_n)$$

where $D_n$ is data to be input to the nth flip-flop and is the data output from the logical gate group connected to the nth flip-flop; $SHT$ is the shift signal; $CNT$ is the count signal and bears a relationship to the shift signal such that $CNT = \overline{SHT}$; $Q_n$ is the Q output from the nth flip-flop; $\overline{Q}_n$ is the $\overline{Q}$ output from the nth flip-flop; $Q_{(n-1)}$ is the Q output from the (n—1)th flip-flop, which is externally supplied input data in the case of the logical gate group connected to the first flip-flop; and $CRY = Q_1 \cdot Q_2 \ldots \cdot Q_{(n-1)}$ and is taken to have the logical value "1" in the case of the logical gate group connected to the first flip-flop.

2. A logical circuit according to claim 1, wherein the logical gate group connected to the nth flip-flop, where n is greater than 1, has a construction which embodies the simplified expression as follows, or the inverse of the simplified expression as follows, or logical equivalents of either,

$$D_n = SHT \cdot Q_{(n-1)} + CRY \cdot \overline{Q}_n + CNT \cdot \overline{CRY} \cdot Q_n.$$

3. A logical circuit according to claim 1 or 2, wherein the externally supplied data is serial input data Sin corresponding to an initial count value to be loaded into the circuit, the circuit being operable as a shift register to shift the initial count value into the flip-flops.

4. A logical circuit according to any preceding claim, wherein the flip-flops are D-type or delay flip-flops.

5. A logical circuit according to claim 1, 2 or 3, wherein the flip-flops are J-K flip-flops.

6. A logical circuit according to any preceding claim, wherein the gate groups employ AND gates and OR gates.

7. A logical circuit according to claim 1, 2, 3, 4 or 5, wherein the gate groups employ NAND gates and AND gates.

8. A logical circuit according to claim 1, 2, 3, 4 or 5, wherein the gate groups employ AND gates and NOR gates.

## Patentansprüche

1. Logikschaltung mit einer Vielzahl von in Kaskade geschalteten Flipflops, mit deren Dateneingangsteil jeweils eine logische Torschaltungsgruppe verbunden ist, wobei die logische Torschaltungsgruppe jedes Flipflops Tore umfaßt, die so angeordnet sind, daß sie durch ein Schiebesignal und durch ein Zählsignal geöffnet und geschlossen werden können, und bei welcher die logischen Torschaltungsgruppen so angeordnet sind, daß die Flipflops dazu dienen, in Abhängigkeit von dem Schiebesignal bzw. dem Zählsignal ein Schieberegister und einen Zähler zu bilden, dadurch gekennzeichnet, daß die logische Torschaltungsgruppe, die mit einem n-ten (n=1, 2, 3, ...) Flipflop verbunden ist, einen Aufbau bildet, welcher den folgenden Ausdruck, sein Inverses oder logische Äquivalente von einem von diesen verkörpert

$$D_n = SHT \cdot Q_{(n-1)} + CNT(CRY \cdot \overline{Q}_n + \overline{CRY} \cdot Q_n)$$

wobei:

$D_n$ die Daten sind, die dem n-ten Flipflop zuzuführen und die Ausgangsdaten der mit dem n-ten Flipflop verbundenen logischen Torschaltungsgruppe sind; SHT das Schiebesignal ist; CNT das Zählsignal ist und mit dem Schiebesignal in einem solchen Verhältnis steht, daß CNT=SHT; $Q_n$ der Q-Ausgang von dem n-ten Flipflop ist; $\overline{Q}_n$ der $\overline{Q}$-Ausgang von dem n-ten Flipflop ist; $Q_{(n-1)}$ der Q-Ausgang von dem (n−1)-ten Flipflop ist, welchem extern Eingangsdaten zugeführt werden, falls die logische Torschaltungsgruppe mit dem ersten Flipflop verbunden ist; und $CRY=Q_1 \cdot Q_2 \ldots \cdot Q_{(n-1)}$ und als logischer Wert "1" angenommen wird, wenn die logische Torschaltungsgruppe mit dem ersten Flipflop verbunden ist.

2. Logikschaltung nach Anspruch 1, bei welcher die logische Torschaltungsgruppe mit dem n-ten Flipflop verbunden ist, wobei n größer als 1 ist, einen Aufbau bildet, welcher den folgenden vereinfachten Ausdruck, oder das Inverse des folgenden vereinfachten Ausdrucks oder logische Äquivalente von einem von beiden verkörpert,

$$D_n = SHT \cdot Q_{(n-1)} + CRY \cdot \overline{Q}_n + CNT \cdot \overline{CRY} \cdot Q_n$$

3. Logikschaltung nach Anspruch 1 oder 2, bei welcher die extern zugeführten Daten serielle Eingangsdaten Sin sind, die einem anfänglichen Zählwert entsprechen, der in die Schaltung geladen werden soll, wobei die Schaltung als Schieberegister arbeitet, um den anfänglichen Zählwert in die Flipflops zu schieben.

4. Logikschaltung nach einem der vorhergehenden Ansprüche, bei welcher die Flipflops vom D-Typ oder Verzögerungsflipflops sind.

5. Logische Schaltung nach Anspruch 1, 2 oder 3, bei welcher die Flipflops J-K-Flipflops sind.

6. Logische Schaltung nach einem der vorhergehenden Ansprüche, bei welcher die Torschaltungsgruppen UND-Tore oder ODER-Tore verwenden.

7. Logikschaltung nach Anspruch 1, 2, 3, 4 oder 5, bei welcher die Torschaltungsgruppen NAND-Tore und UND-Tore verwenden.

8. Logikschaltung nach Anspruch 1, 2, 3, 4 oder 5, bei welcher die Torschaltungsgruppen UND-Tore und NOR-Tore verwenden.

**Revendications**

1. Circuit logique comprenant plusieurs circuits bistables connectés en cascade, chaque circuit bistable étant connecté par sa partie d'entrée de données à un groupe de portes logiques, le groupe de portes logiques de chaque circuit bistable comprenant des portes disposées pour être ouvertes et fermées par un signal de décalage et par un signal de comptage, les groupes de portes logiques étant disposés de manière que les circuits bistables servent alternativement à former un registre à décalage et un compteur en réponse au signal de décalage et au signal de comptage respectivement, caractérisé en ce que le groupe de portes logiques connectées à un nième (n=1, 2, 3 ...) circuit bistable est réalisé de manière à appliquer l'expression suivante, ou son inverse, ou des équivalents logiques,

$$D_n = SHT \cdot Q_{(n-1)} + CNT(CRY \cdot \overline{Q}_n + \overline{CRY} \cdot Q_n)$$

où $D_n$ sont les données à introduire au nième circuit bistable et les données émises par le groupe de portes logiques connectées au nième circuit bistable; SHT est le signal de décalage; CNT est le signal de comptage en relation avec le signal de décalage de manière que CNT=SHT; $Q_n$ est la sortie Q du nième circuit bistale; $\overline{Q}_n$ est la sortie $\overline{Q}$ du nième circuit bistable, $Q_{(n-1)}$ est la sortie Q du (n−1) ième circuit bistable qui reçoit extérieurement des données d'entrée dans le cas du groupe de portes logiques connectées au premier circuit bistable; et $CRY=Q_1 \cdot Q_2 \ldots Q_{(n-1)}$ et est pris à la valeur logique "1" dans le cas du groupe de portes logiques connectées au premier circuit bistable.

2. Circuit logique selon la revendication 1, dans lequel le groupe de portes logiques connectées au nième circuit bistable, où n est supérieur à l'unité, est réalisé de manière à appliquer l'expression simplifiée ci-après, ou l'inverse de l'expression simplifiée ci-après ou des équivalents logiques de l'un ou l'autre,

$$D_n = SHT \cdot Q_{(n-1)} + CRY \cdot \overline{Q}_n + CNT \cdot \overline{CRY} \cdot Q_n$$

3. Circuit logique selon la revendication 1 ou 2 dans lequel les données fournies extérieurement sont des données d'entrée en série Sin correspondant à une valeur de comptage initiale à charger dans le circuit, le circuit pouvant fonctionner comme un registre à décalage pour décaler la valeur de comptage initiale dans les circuits bistables.

4. Circuit logique selon l'une des revendications précédentes, dans lequel les circuits bistables sont des circuits bistables à retard ou de type D.

5. Circuit logique selon la revendication 1, 2 ou 3, dans lequel les circuits bistables sont des circuits bistables J ou K.

6. Circuit logique selon l'une des revendications précédentes, dans lequel les groupes de portes comprennent des portes ET et des portes OU.

7. Circuit logique selon la revendication 1, 2, 3, 4 ou 5, dans lequel les groupes de portes comprennent des portes NON et des portes ET.

8. Circuit logique selon la revendication 1, 2, 3, 4 ou 5 dans lequel les groupes de portes comportent des portes ET et des portes NON-OU.

FIG. 1

FIG. 2

SHIFT LOAD

SHIFT DATA IN    COUNT LOAD

LOAD CIRCUIT    1-1    CARRY IN
D TYPE F.F    GATE CKT    3-1    J-K F.F    4-1
D  QA    J  QA
T    T
Q̄A    K  Q̄A

1-2    2-1

D  QB    3-2
T    J  QB
Q̄B    T
1-3    2-2    K  QB    4-2

D  Qc    3-3
T    J  Qc
Q̄c    T
1-4    2-3    K  Q̄c    4-3

D  Q_D    3-4
T    J  Q_D
Q̄_D    T
2-4    K  Q̄_D    4-4

SHIFT CLEAR

SHIFT CLOCK    CARRY OUT CKT
CARRY OUT
SERIAL OUT    COUNT CLEAR    5
COUNT CLOCK

2

**0 031 638**

# FIG. 3

# FIG. 4

# FIG. 5

3

# FIG. 6

# FIG. 7

FIG. 8

0 031 638

## FIG. 9

## FIG. 10

## FIG. 11